# EUROPÄISCHE PATENTSCHRIFT

(11) **EP 1 730 758 B1**
(45) Veröffentlichungstag und Bekanntmachung des Hinweises auf die Patenterteilung: **10.06.2009**
(21) Anmeldenummer: 05729799.6
(22) Anmeldetag: 31.03.2005
(51) Int. Cl.: H01G 9/20

(54) **Photoelektrochemisches Solarzellenmodul**
Photo-electrochemical solar cell module
Module de cellules solaires photo-électrochimiques

(30) Priorität: 31.03.2004 DE 102004015769
(43) Veröffentlichungstag der Anmeldung: 13.12.2006
(73) Patentinhaber: Fraunhofer-Gesellschaft zur Förderung der angewandten Forschung e.V., 80686 München (DE); Albert-Ludwigs-Universität Freiburg, 79098 Freiburg (DE)
(72) Erfinder: HINSCH, Andreas, 79254 Oberried (DE); BELLEDIN, Udo, 79291 Merdingen (DE); SASTRAWAN, Ronald, 79100 Freiburg (DE); GEORG, Andreas, 79104 Freiburg (DE)
(74) Vertreter: Pfenning, Meinig & Partner GbR
(86) Internationale Anmeldenummer: PCT/EP2005/003372
(87) Internationale Veröffentlichungsnummer: WO 2005/096391

(56) Entgegenhaltungen:
- WO-A-96/29716
- WO-A-20/04006381

## Beschreibung

Die Erfindung betrifft ein photoelektrochemisches Solarzellenmodul aus mindestens zwei Solarzellen mit einem ersten und einem zweiten Substrat, zwischen denen eine transparente elektrisch leitende Schicht, eine poröse Farbstoffträgerschicht, eine elektrisch isolierende Separierschicht und eine zweite elektrisch leitende Schicht angeordnet sind. Die Solarzellen sind hierbei durch einen isolierenden Steg, der zumindest bereichsweise eine Leiterbahn einschließt, voneinander getrennt, wobei jede Solarzelle mindestens eine Befüllöffnung für die Befüllung der Solarzelle mit einem Farbstoff und/oder einem Elektrolyten aufweist.

Aus der WO 91/16719 und B. O'Regan, M. Grätzel, Nature 353 (1991) 737 ist eine Photoelektrochemische Solarzelle bekannt, bei welcher zwischen zwei Substraten zwei Elektroden eingeschlossen sind. Die eine Elektrode umfasst ein poröses Trägermaterial mit hoher innerer Oberfläche, vorzugsweise aus TiO₂, aber auch anderen Materialien, auf das idealerweise als monomolekulare Schicht ein Farbstoff aufgebracht ist.

Unter Beleuchtung wird dieser Farbstoff angeregt und er injiziert Elektronen in das Trägermaterial. Der Farbstoff steht weiter in Kontakt mit einem zweiten Material, das ein Redoxpaar enthält (vorzugsweise ein in einem Elektrolyten gelöstes Redoxsalz mit I⁻ und I₃⁻ als Anionen), welches Elektronen an den Farbstoff abzugeben in der Lage ist. Neben in einem Elektrolyt gelösten Redoxsalzen (vorzugsweise Iodide in organischen Lösungsmitteln) sind auch sog. "molten salts" bekannt.

Elektronisch leitfähige Schichten sammeln die Elektronen von dem porösen Trägermaterial ein, da in der Regel die Leitfähigkeit des Trägermaterials nicht ausreicht. Die oxidierten Ionen des Redoxsalzes (z.B. I₃⁻) diffundieren durch den Elektrolyt zu einer zweiten leitfähigen Schicht, der Gegenelektrode, die Elektronen an das oxidierte Ion abgeben kann. Vorzugsweise werden diese leitfähigen Schichten kombiniert mit den Elektronenübergang katalysierenden Materialien, wie z.B. Platin, Rhodium oder Graphit.

Diese Elektroden können nun in unterschiedlichster Form angeordnet sein. Bekannt sind hierzu z.B. die Beschreibungen aus WO 96/29716, DE 4221084 A1, WO 00/48212, WO 00/46860. Grundsätzlich können die beiden Elektroden, d.h. Trägermaterial und elektronisch leitende Schicht als "Arbeitselektrode" und zweite elektronisch leitende Schicht bevorzugt kombiniert mit katalytischen Eigenschaften als "Gegenelektrode", einander gegenüberliegend auf zwei Substraten aufgebracht werden oder in einem monolithischem Aufbau als ein auf einem Substrat aufgebrachtes Mehrschichtsystem aufgebracht werden. Bei diesem monolithischen Aufbau ist dann eine zusätzliche Schicht, die die Arbeitselektrode von der Gegenelektrode trennt, notwendig. Diese soll hier "Separierschicht" genannt werden. Sie besteht vorzugsweise aus einem porösen, elektronisch isolierendem Material, wie z.B. ZrO₂.

Weitere Schichten oder Materialmodifikationen in den beschriebenen Schichten können zusätzlich eine optische Funktion haben, insbesondere Lichtstreuung und/oder Lichtreflexion. Dadurch können bei geringeren Schichtdicken die Lichtwege erhöht und das Licht besser genutzt werden.

In der Regel muss eine der beiden leitfähigen Schichten transparent sein. Die hierzu verfügbaren Materialien weisen jedoch eine vergleichsweise geringe Leitfähigkeit auf, d.h. der Gesamtwirkungsgrad einer Solarzellenanordnung wird merklich durch die begrenzte Leitfähigkeit der transparenten Elektrode reduziert.

Somit ergibt sich die Forderung nach metallisch leitenden Leiterbahnen zur Unterstützung der elektrischen Leitung der Elektroden, z.B. Silber.

Bevorzugte Redoxsalze (z.B. I⁻/I₃⁻) korrodieren das Silber (und viele andere Metalle, wie Kupfer, Aluminium oder sogar Gold) und somit müssen die Leiterbahnen vor dem Elektrolyt geschützt werden. Dies kann z.B. durch ein Glaslot geschehen. Dies wird z.B. in WO 00/48212 oder in WO 96/29716 beschrieben. Nachteilig erweist sich hier, dass die hier beschriebenen Anordnungen der Isolierung auf den Leiterbahnen anfällig gegenüber "pinholes" in den Isolierungen sind, wie sie z.B. durch Staubeinwirkung auftreten können. Tritt ein solches pinhole auf, dann dringt das Redoxsalz in die Leiterbahn ein und kann unter der Isolierung entlang der Leiterbahn diffundieren und so das ganze Modul schädigen.

Insbesondere auch die in WO 96/29716 beschriebenen Kreuzungen (Übereinanderführungen) von Leiterbahnen und Elektrolyt-Kanälen bergen diese Gefahr in sich.

Eine andere Anforderung ergibt sich aus der Verwendung flüssiger oder zumindest zähflüssiger Elektrolyte, da sich diese durch besonders hohe Ionenleitfähigkeiten positiv auszeichnen. Dies erfordert ein Befüllen der Zelle mit Flüssigkeit. Besonders vorteilhaft ist es, mit möglichst wenigen Befülllöchern auszukommen, da das Befüllen und das anschließende Verschließen der Befülllöcher einen vergleichsweise hohen Aufwand darstellt.

Zur Herstellung der hier beschriebenen photoelektrochemischen Solarzelle eigenen sich besonders Druckverfahren, so dass eine kostengünstige Massenfertigung gut möglich ist. Hierzu können die beiden Elektrolyten separat auf zwei gegenüberliegenden Substanzen aufgebracht werden, oder nacheinander auf ein Substrat, getrennt durch eine poröse Isolierschicht. Bei diesem monolithischen Aufbau werden die porösen Schichten von dem (zäh-)flüssigen Elektrolyten durchtränkt. Dieser Aufbau ist von Vorteil für eine auch auf größeren Flächen kleinen und konstanten Abstand der beiden Elektroden, bei dem Welligkeiten der Substrate noch in einem vergleichsweise großem Maße toleriert werden können.

Die in bevorzugter Weise verwendeten Materialien erfordern eine gute Versiegelung des Systems. Bevorzugt sind hier versiegelungsmaterialien, die durch Aufschmelzen mit den Substraten verbunden werden. Solarzellen weisen typischerweise Betriebstemperaturen bis 70° C auf. Versiegelungsmaterialien sollten also in diesem Bereich noch undurchlässig für von außen kommende Verunreinigungen, wie z.B. Wasser oder Sauerstoff, und für flüchtige Komponenten innerhalb des Zellsystems sein. Besonders geeignet sind Glaslotmaterialien, die typischerweise oberhalb 550° C aufschmelzen und eine gute Stabilität des Gesamtsystems gewährleisten. Diese können auch in Druckverfahren aufgebracht werden und erfordern einen Thermalisierungsschritt.

Die bevorzugt verwendeten Farbstoffe sind bei diesen Temperaturen nicht stabil, müssen also nach der Versiegelung aufgebracht werden. Sie können entweder in einer Farbstofflösung durch die Befüllöffnungen eingefüllt werden. Nach einer Adsorption des Farbstoffes auf dem porösen Trägermaterial kann die Lösung dann wieder abgepumpt und der Elektrolyt eingefüllt werden. Alternativ kann der Farbstoff in wohldosierter Form, bevorzugt in kolloidaler Form, zusammen mit dem Elektrolyt eingebracht werden. Man kommt dabei mit einem Befüllvorgang aus (vgl. WO 96/29716).

Allgemein ist es bei Solarzellenanordnungen von Vorteil, Einzelzellen in Reihe (zur Erhöhung der Spannung) und parallel (zur Erhöhung des Stroms) zu verschalten. Eine Reihenschaltung zweier Zellen erfordert die Trennung des Elektrolyten der beiden Zellen und eine Verbindung der Elektroden. Bei einer Parallelschaltung ist der Einsatz von hochleitenden Leiterbahnen besonders wichtig.

Für Farbstoff-sensibilisierte Solarzellen ist es günstig, einen monolithischen Schichtaufbau (Farbstoffträgerschicht (z.B. TiO₂), Separierschicht (z.B. ZrO₂) und Gegenelektrode (z.B. Graphit oder Platin)), gut elektrisch leitende Leiterbahnen (z.B. Silber) so wie zur Versiegelung und zum Schutz von Leiterbahnen vor Korrosion und zur Trennung des gesamten Modulvolumens in einzelne, dann in Serie verschaltbare Kammerbereiche, hochschmelzende Materialien (z.B. Glaslot) auf ein Glassubstrat aufzudrucken und zusammen mit einer Glasgegenplatte zu temperieren. Der Farbstoff und der aufgrund seiner hohen Leitfähigkeit bevorzugte flüssige Elektrolyt werden günstigerweise nachträglich in die Hohlräume gefüllt. Aufgabe der Erfindung ist es daher, eine Anordnung zu finden, die möglichst wenige Befülllöcher und keine Kreuzungen aus Leiterbahnen und Elektrolyträumen aufweist, so dass die Leiterbahnen ganz aus isolierendem Material eingeschlossen werden können.

Diese Aufgabe wird durch das gattungsgemäße photoelektrochemische Solarzellenmodul mit den kennzeichnenden Merkmalen des Anspruchs 1 gelöst. Die weiteren abhängigen Ansprüche zeigen vorteilhafte Weiterbildungen auf.

Erfindungsgemäß wird ein photoelektrochemisches Solarzellenmodul aus mindestens zwei Solarzellen mit einem ersten und einem zweiten Substrat bereitgestellt. Zwischen den Substraten ist dabei eine transparente, elektrisch leitende Schicht, eine poröse Farbstoffträgerschicht, eine elektrisch isolierende Separierschicht und eine zweite elektrisch leitende Schicht angeordnet, wobei die Solarzellen durch einen isolierenden Steg, der zumindest bereichsweise eine Leiterbahn einschließt, voneinander getrennt sind. Jede Solarzelle weist dabei mindestens eine Befüllöffnung für die Befüllung der Solarzelle mit einem Farbstoff und/oder einem Elektrolyten auf.

Die Besonderheit des photoelektrochemischen Solarzellenmoduls beruht nun darauf, dass die zweite elektrisch leitende Schicht an der der Separierschicht abgewandten Seite eine kanalartige und/oder abstandshaltende Profilierung unter Ausbildung von Hohlräumen zur Aufnahme und Weiterleitung des Farbstoffs und/oder Elektrolyten aufweist, und dass die einzlenen Solarzellen mäander Förmig angerodnet sind.

Der Vorteil der kanalartigen Profilierung beruht darauf, dass eine verbesserte Verteilung des Farbstoffs und/oder Elektrolyten in der Zelle realisiert werden kann, wodurch der Einfärbevorgang deutlich beschleunigt wird. Dazu ermöglich die mäander Förmige Anordnung der eizelnen Solarzellen eine Optimierung des Platzbedarfes und die Anzahl der Löcher wird dadurch deutlich reduziert.

Besonders vorteilhaft ist es, wenn die Leiterbahnen vollständig durch den isolierenden Steg eingeschlossen sind, d.h. dass über der Leiterbahn ein isolierender Steg aufgebracht wird, der den Zwischenraum zwischen den beiden Substraten vollständig ausfüllt und dass dieser isolierende Steg gleichzeitig eine Trennung der Elektrolytkammern bewirkt. Durch geeignete Anordnung dieser kombinierten Leiterbahn-Isolierstege kann eine große Fläche mit einer zusammenhängen Isolierkammer abgedeckt werden, was die Anzahl der Einfülllöcher reduziert, gleichzeitig erhält man einen geringen Serienwiderstand der Zelle.

Vorzugsweise besteht zumindest ein Substrat aus Glas, wie z.B. herkömmlichem Floatglas.

Die transparente elektrisch leitende Schicht kann aus beliebigen Materialien, die diese physikalischen Eigenschaften aufweisen, hergestellt sein, wobei vorzugsweise fluordotiertes Zinnoxid (F:SnO₂) verwendet wird.

Als poröse Farbstoffträgerschicht wird vorzugsweise Titandioxid (TiO₂) eingesetzt.

Die elektrisch isolierende Separierschicht kann aus beliebigen Materialien mit diesen physikalischen Eigenschaften bestehen, bevorzugt werden hierzu Zirkoniumoxid (ZrO₂), Siliziumoxid (SiO₂), Aluminiumoxid (Al₂O₃) und/oder Tantaloxid (Ta₂O₅) verwendet.

Die zweite elektrisch leitende Schicht besteht vorzugsweise aus Graphit, Ruß und/oder Platin.

Bevorzugte Leiterbahnmaterialien sind ausgewählt aus der Gruppe Gold, Silber, Kupfer und/oder Palladium-Silber-Legierungen.

Vorzugsweise sind die isolierenden Stege aus Glaslot gebildet, da dies eine vereinfachte Herstellung mit sich bringt.

Erfindungsgemäß wird bevorzugt als Farbstoff eine Verbindung der allgemeinen Formel I

ML₂X₂ I

mit L = 2,2'-Bipyridyl-4,4'-dicarboxylsäure
M = Ru, Os,
X = Halogen, CN, SCN
eingesetzt. Als besonders bevorzugter Farbstoff gilt hier cis-RuL₂(NCS)₂.

Bei dem erfindungsgemäßen Aufbau sind die einzelnen Kammern der Solarzelle vorzugsweise in Serie verschaltet. Dabei ist es bevorzugt, dass die Solarzelle eine Elektrolytkammer aufweist, die von der zweiten elektrisch leitenden Schicht, dem isolierenden Steg sowie einem der Substrate begrenzt ist.

Vorzugsweise weist das Solarzellenmodul einen monolithischen Aufbau auf, da dieser Aufbau den Vorteil besitzt, dass auch bei größeren Flächen bei kleinen und konstanten Abständen der beiden Elektroden Welligkeiten der Substrate noch in verhältnismäßig hohem Maße toleriert werden können.

Anhand der nachfolgenden Figuren soll der erfindungsgemäße Gegenstand näher erläutert werden, wobei diese exemplarischen Ausführungsformen das durch die Ansprüche festgelegte Schutzbegehren nicht beschränken.

Anhand der nachfolgenden Figuren soll der anmeldungsgemäße Gegenstand mehr beschrieben werden, ohne dass diese den Schutzbereich der Erfindung einschränken soll.
- Fig. 1: zeigt einen Querschnitt einer Variante eines erfindungsgemäßen Solarzellenmoduls.
- Fig. 2: zeigt zwei Varianten von eingeschlossenen Leiterbahnen zwischen den Substraten.
- Fig. 3: zeigt eine Draufsicht auf eine erste Variante einer Zellenanordnung.
- Fig. 4: zeigt eine Draufsicht auf eine weitere erfindungsgemäße Zellanordnung.
- Fig. 5: zeigt eine Variante einer kanalartigen bzw. abstandshaltenden Profilierung der elektrisch leitenden Schicht.
- Fig. 6: zeigt eine erfindungsgemäße Drainagestruktur des Solarzellenmoduls.

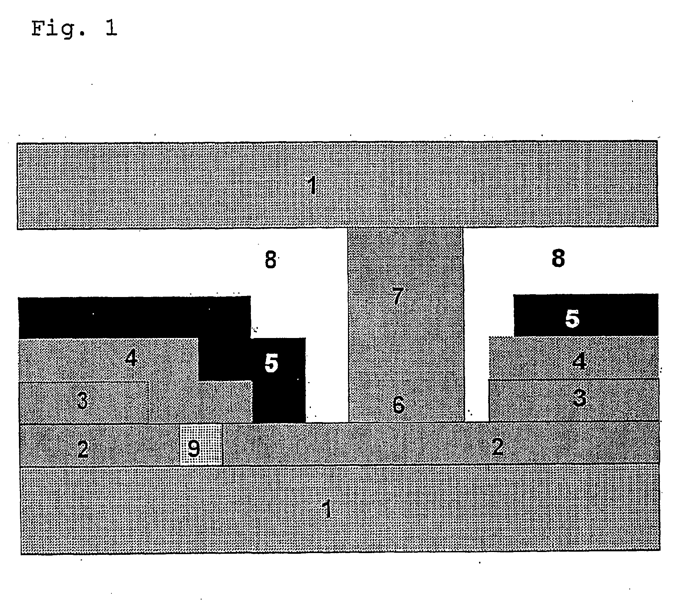

Die in Fig. 1 dargestellte Variante eines Solarzellenmoduls wird an der Ober- und Unterseite von einem Substrat 1 begrenzt. Auf dem ersten Substrat 1, das z. B. aus Glas besteht, ist eine transparente elektrisch leitende Schicht, z. B. aus fluordotiertem Zinnoxid aufgebracht. Die transparente elektrisch leitende Schicht 2 enthält eine Ausnehmung 9, die durch Lasertechnik in diese Schicht eingeätzt wurde. Das Solarzellenmodul weist weiterhin eine Trägerschicht 3 auf, die gegebenenfalls von einer Separierschicht 4 überdeckt ist. Als Gegenelektrode 5 eignet sich z. B. eine Graphit-Elektrode. Die im Zentrum angeordnete. Leiterbahn, die z. B. aus Silber bestehen kann, ist in der vorliegenden Variante von einer Isolation in Form eines Kammertrennsteges, z. B. aus Glaslot, eingeschlossen. Dieser trennt die einzelnen Kammerräume 8 voneinander. Die vorliegenden Schichten 3, 4, 5 und 8 sind porös und mit einem flüssigen Elektrolyten, der ein Redoxsalz enthält, gefüllt. Die Beleuchtung eines derartigen Solarzellenmoduls erfolgt von der Unterseite.

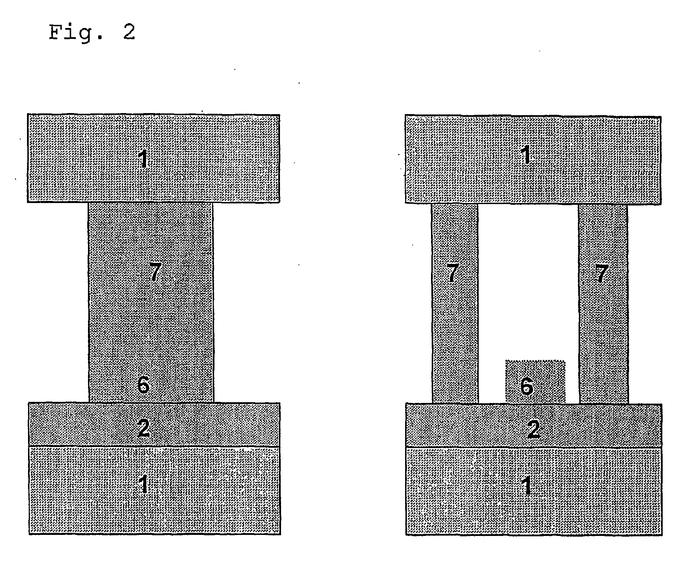

Fig. 2 zeigt eine erste Variante a) einer eingeschlossenen Leiterbahn, bei der die Leiterbahn 6 vollständig von der Isolation 7 umschlossen ist. Auch hier ist die Leiterbahn 6 auf der transparenten elektrisch leitenden Schicht 2 aufgebracht und das Solarzellenmodul durch die beiden Substrate 1 eingeschlossen. Die zweite Variante b) zeigt eine weitere Variante für den Einschluss der Leiterbahn. Hierbei ist die Leiterbahn durch zwei Isolationsstege 7 vom Kammerraum abgetrennt.

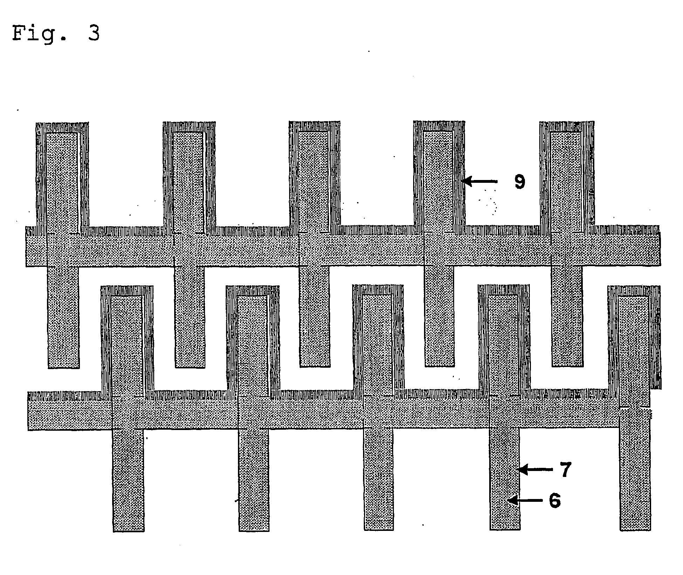

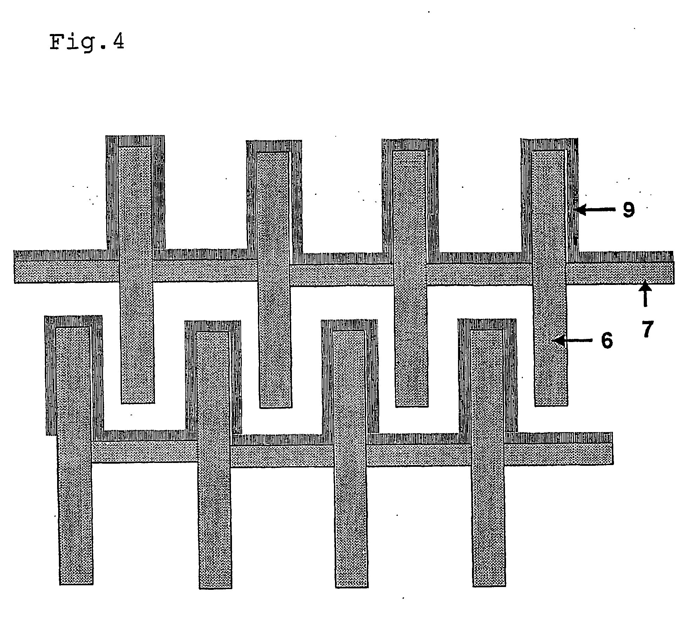

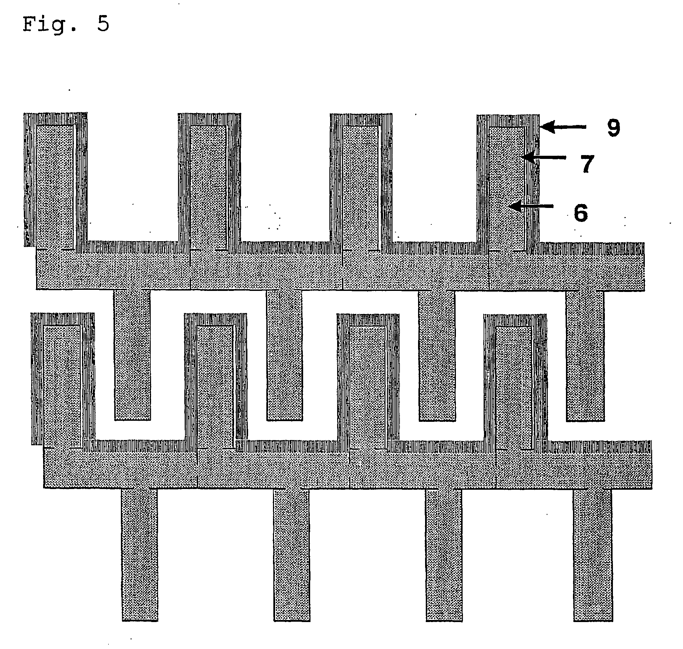

In Fig. 3 ist eine Variante einer mäanderförmigen Anordnung eines erfindungsgemäßen Solarzellenmoduls dargestellt. Hierbei sind nur die Leiterbahnen 6, die Isolationen und Trennstege 7 und die Ausnehmungen in der transparenten elektrisch leitenden Schicht 9 dargestellt. Das gleiche betrifft die Figuren 4 und 5, wobei diese zusätzliche Anordnungsvarianten hinsichtlich der Mäanderstruktur des Solarzellenmoduls darstellen.

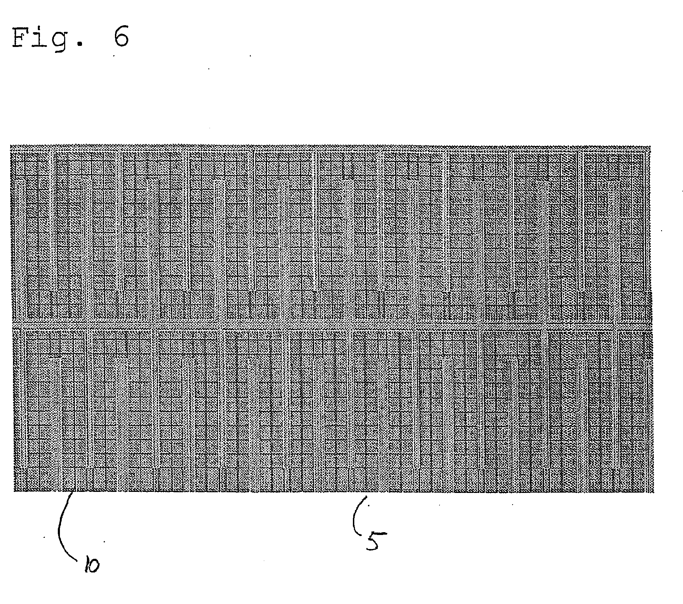

Fig. 6 zeigt beispielhaft eine Variante der so genannten Drainagestruktur des Solarzellenmoduls. Hierbei weist die zweite elektrisch leitende Schicht 5 an der der Separierschicht abgewandten Seite eine kanalartige Profilierung 10 auf. Diese kanalartige Profilierung ist in der Zeichnung rasterartig dargestellt. Zwischen den hier dargestellten einzelnen Kacheln verlaufen Vertiefungen, die die kanalartigen Profilierungen 10 bilden. Weiterhin sind in der Figur noch die mäanderförmigen Strukturen des Solarzellenmoduls zu erkennen. Bei dieser Struktur wird die Befüllung des Solarzellenmoduls mit Farbstoff oder Elektrolyt und die entsprechende Weiterleitung durch das gesamte Modul deutlich erleichtert.

## Patentansprüche

1. Photoelektrochemisches Solarzellenmodul aus mindestens zwei Solarzellen mit einem ersten (1) und einem zweiten Substrat (1'), zwischen denen eine transparente elektrisch leitende Schicht (2), eine poröse Farbstoffträgerschicht (3) eine elektrisch isolierende Separierschicht (4) und eine zweite elektrisch leitende Schicht (5) angeordnet sind, wobei die Solarzellen durch einen isolierenden Steg (7), der zumindest bereichsweise eine Leiterbahn (6) einschließt, voneinander getrennt sind und jede Solarzelle mindestens eine Befüllöffnung für die Befüllung der Solarzelle mit einem Farbstoff und/oder einem Elektrolyten aufweist,
**dadurch gekennzeichnet,**
**dass** die zweite elektrisch leitende Schicht (5) an der der Separierschicht (4) abgewandten Seite eine kanalartige und/oder abstandshaltende Profilierung als Drainagestruktur unter Ausbildung von Hohlräumen zur Aufnahme und Weiterleitung des Farbstoffs und/oder Elektrolyten aufweist und dass die einzelnen Solarzellen mäanderförmig angeordnet sind.

2. Solarzellenmodul nach Anspruch 1,
**dadurch gekennzeichnet, dass** zumindest ein Substrat aus Glas, wie z.B. Floatglas, besteht.

3. Solarzellenmodul nach einem der Ansprüche 1 oder 2,
**dadurch gekennzeichnet, dass** die transparente elektrisch leitende Schicht (2) aus fluordotiertem Zinnoxid (SnO₂) besteht.

4. Solarzellenmodul nach einem der Ansprüche 1 bis 3,
**dadurch gekennzeichnet, dass** die poröse Farbstoffträgerschicht (3) aus Titandioxid (TiO₂) besteht.

5. Solarzellenmodul nach einem der Ansprüche 1 bis 4,
**dadurch gekennzeichnet, dass** die elektrisch isolierende Separierschicht (4) aus Zirkoniumoxid (ZrPO₂), Siliciumoxid (SiO₂), Aluminiumoxid (Al₂O₃) und/oder Tantaloxid (Ta₂O₅) besteht.

6. Solarzellenmodul nach einem der Ansprüche 1 bis 5,
**dadurch gekennzeichnet, dass** die zweite elektrisch leitende Schicht (5) aus Graphit, Ruß und/oder Platin besteht.

7. Solarzellenmodul nach einem der Ansprüche 1 bis 6,
**dadurch gekennzeichnet, dass** die Leiterbahn (6) aus Gold, Silber, Kupfer und/oder Palladium-Silber-Legierungen besteht.

8. Solarzellenmodul nach einem der Ansprüche 1 bis 7,
**dadurch gekennzeichnet, dass** die isolierenden Stege aus Glaslot gebildet sind.

9. Solarzellenmodul nach einem der Ansprüche 1 bis 8,
**dadurch gekennzeichnet, dass** der Farbstoff eine organische oder metallorganische Verbindung ist.

10. Solarzellenmodul nach einem der Ansprüche 1 bis 9,
**dadurch gekennzeichnet, dass** der Farbstoff eine Verbindung der allgemeinen Formel I
ML₂X₂ I
mit L = 2,2'-Bipyridyl-4,4'-dicarboxylsäure
M = Ru, Os,
X = Halogen, CN, SCN.

11. Solarzellenmodul nach Anspruch 10,
**dadurch gekennzeichnet, dass** der Farbstoff cis-RuL₂(NCS)₂ ist.

12. Solarzellenmodul nach einem der Ansprüche 1 bis 11,
**dadurch gekennzeichnet, dass** die einzelnen Kammern der Solarzelle in Serie verschaltet sind.

13. Solarzellenmodul nach einem der Ansprüche 1 bis 12,
**dadurch gekennzeichnet, dass** die Solarzelle eine Elektrolytkammer (8) aufweist, die von der zweiten elektrisch leitenden Schicht (5), dem isolierenden Steg (7) und einem der Substrate (1, 1') begrenzt ist.

14. Solarzellenmodul nach einem der Ansprüche 1 bis 13,
**dadurch gekennzeichnet, dass** das Solarzellenmodul einen monolithischen Aufbau aufweist.

15. Solarzellenmodul nach einem der Ansprüche 1 bis 14,
**dadurch gekennzeichnet, dass** die Leiterbahnen Unterbrechungen aufweisen.

## Claims

1. Photoelectrochemical solar cell module comprising at least two solar cells having a first substrate (1) and a second substrate (1'), between which a transparent electrically conductive layer (2), a porous dye carrier layer (3), an electrically insulating separating layer (4) and a second electrically conductive layer (5) are arranged, the solar cells being separated from one another by an insulating web (7) which encloses, in a least some areas, a conductor track (6) and each solar cell having at least one filling opening for filling the solar cell with a dye and/or an electrolyte,
**characterised**
**in that** the second electrically conductive layer (5) has, on the side facing away from the separating layer (4), a channel-like and/or spacing profiling as a drainage structure forming hollow spaces for receiving and transmitting the dye and/or electrolyte, and in that the individual solar cells are arranged in a meander-shape.

2. Solar cell module according to Claim 1,
**characterised in that** at least one substrate is composed of glass, such as, for example, float glass.

3. Solar cell module according to one of Claims 1 and 2,
**characterised in that** the transparent electrically conductive layer (2) is composed of fluorine-doped tin oxide (SnO₂).

4. Solar cell module according to one of Claims 1 to 3,
**characterised in that** the porous dye carrier layer (3) is composed of titanium dioxide (TiO₃).

5. Solar cell module according to one of Claims 1 to 4,
**characterised in that** the electrically insulating separating layer (4) is composed of zirconium oxide (ZrO₂), silicon oxide (SiO₂), aluminium oxide (Al₂O₃) and/or tantalum oxide (Ta₂O₅).

6. Solar cell module according to one of Claims 1 to 5,
**characterised in that** the second electrically conductive layer (5) is composed of graphite, carbon black and/or platinum.

7. Solar cell module according to one of Claims 1 to 6,
**characterised in that** the conductor track (6) is composed of gold, silver, copper and/or palladium-silver alloys.

8. Solar cell module according to one of Claims 1 to 7,
**characterised in that** the insulating webs are formed from solder glass.

9. Solar cell module according to one of Claims 1 to 8,
**characterised in that** the dye is an organic or organometallic compound.

10. Solar cell module according to one of Claims 1 to 9,
**characterised in that** the dye is a compound of the general formula I
ML₂X₂ I
where L = 2,2'-bipyridyl-4,4'-dicarboxylic acid
M = Ru, Os,
X = halogen, CN, SCN.

11. Solar cell module according to Claim 10,
**characterised in that** the dye is cis-RuL₂(NCS)₂.

12. Solar cell module according to one of Claims 1 to 11,
**characterised in that** the individual chambers of the solar cell are connected in series.

13. Solar cell module according to one of Claims 1 to 12,
**characterised in that** the solar cell has an electrolyte chamber (8) which is bounded by the second electrically conductive layer (5), the insulating web (7) and one of the substrates (1, 1').

14. Solar cell module according to one of Claims 1 to 13,
**characterised in that** the solar cell module has a monolithic structure.

15. Solar cell module according to one of Claims 1 to 14,
**characterised in that** the conductor tracks have interruptions.

## Revendications

1. Module de cellule solaire photo-électrochimique constitué d'au moins deux cellules solaires avec un premier substrat (1) et un second substrat (1') entre lesquels sont disposées une couche électriquement conductrice (2) transparente, une couche de support de colorant (3) poreuse, une couche de séparation (4) électriquement isolante et une seconde couche électriquement conductrice (5), les cellules solaires étant séparées l'une de l'autre par une cloison isolante (7) qui enferme au moins par endroits une piste conductrice (6), et chaque cellule solaire présentant au moins une ouverture de remplissage pour le remplissage de la cellule solaire avec un colorant et/ou un électrolyte,
**caractérisé**
**en ce que** la seconde couche électriquement conductrice (5) présente, sur la face opposée à la couche de séparation (4), un profilage de type canal et/ou d'écartement servant de structure de drainage et formant des cavités pour recevoir et conduire le colorant et/ou l'électrolyte, et en ce que les différentes cellules solaires sont disposées en méandres.

2. Module de cellule solaire selon la revendication 1,
**caractérisé en ce qu'**au moins un substrat est en verre, par exemple en verre flotté.

3. Module de cellule solaire selon l'une quelconque des revendications 1 ou 2,
**caractérisé en ce que** la couche électriquement conductrice (2) transparente est en oxyde de zinc (SnO₂) dopé au fluor.

4. Module de cellule solaire selon l'une quelconque des revendications 1 à 3,
**caractérisé en ce que** la couche de support de colorant (3) poreuse est en dioxyde de titane (TiO₂).

5. Module de cellule solaire selon l'une quelconque des revendications 1 à 4,
**caractérisé en ce que** la couche de séparation (4) électriquement isolante est en oxyde de zirconium (ZrO₂), oxyde de silicium (SiO₂), oxyde d'aluminium (Al₂O₃) et/ou oxyde de tantale (Ta₂O₅).

6. Module de cellule solaire selon l'une quelconque des revendications 1 à 5,
**caractérisé en ce que** la seconde couche électriquement conductrice (5) est en graphite, noir de carbone et/ou platine.

7. Module de cellule solaire selon l'une quelconque des revendications 1 à 6,
**caractérisé en ce que** la piste conductrice (6) est en or, argent, cuivre et/ou en alliages de palladium et argent.

8. Module de cellule solaire selon l'une quelconque des revendications 1 à 7,
**caractérisé en ce que** les cloisons isolantes sont formées en verre de soudure.

9. Module de cellule solaire selon l'une quelconque des revendications 1 à 8,
**caractérisé en ce que** le colorant est un composé organique ou métallo-organique.

10. Module de cellule solaire selon l'une quelconque des revendications 1 à 9,
**caractérisé en ce que** le colorant est un composé de formule générale (I)
ML₂X₂ (I)
où
L = acide 2,2'-bipyridyl-4,4'-dicarboxylique
M = Ru, Os,
X = halogène, CN, SCN.

11. Module de cellule solaire selon la revendication 10,
**caractérisé en ce que** le colorant est cis-RuL₂(NCS)₂.

12. Module de cellule solaire selon l'une quelconque des revendications 1 à 11,
**caractérisé en ce que** les différentes chambres de la cellule solaire sont couplées en série.

13. Module de cellule solaire selon l'une quelconque des revendications 1 à 12,
**caractérisé en ce que** la cellule solaire comporte une chambre à électrolyte (8) qui est délimitée par la seconde couche électriquement conductrice (5), la cloison isolante (7) et l'un des substrats (1,1').

14. Module de cellule solaire selon l'une quelconque des revendications 1 à 13,
**caractérisé en ce que** le module de cellule solaire présente une construction monolithique.

15. Module de cellule solaire selon l'une quelconque des revendications 1 à 14,
**caractérisé en ce que** les pistes conductrices présentent des interruptions.
